(19) Europäisches Patentamt / European Patent Office / Office européen des brevets

(11) **EP 4 343 867 A1**

(12) **EUROPEAN PATENT APPLICATION**
published in accordance with Art. 153(4) EPC

(43) Date of publication:
**27.03.2024 Bulletin 2024/13**

(21) Application number: **22802879.1**

(22) Date of filing: **08.04.2022**

(51) International Patent Classification (IPC):
**H01L 35/16** *(2006.01)*    **H01L 35/34** *(2006.01)*

(52) Cooperative Patent Classification (CPC):
**H10N 10/01; H10N 10/852**

(86) International application number:
**PCT/JP2022/017376**

(87) International publication number:
**WO 2022/244546 (24.11.2022 Gazette 2022/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.05.2021 JP 2021084958**

(71) Applicant: **Panasonic Intellectual Property
Management Co., Ltd.
Kadoma-shi, Osaka 571-0057 (JP)**

(72) Inventors:
• **ANDO, Fuyuki
  Kadoma-shi, Osaka 571-0057 (JP)**
• **KANEKO, Yuriko
  Kadoma-shi, Osaka 571-0057 (JP)**
• **KANNO, Tsutomu
  Kadoma-shi, Osaka 571-0057 (JP)**
• **TAMAKI, Hiromasa
  Kadoma-shi, Osaka 571-0057 (JP)**

(74) Representative: **Grünecker Patent- und
Rechtsanwälte
PartG mbB
Leopoldstraße 4
80802 München (DE)**

(54) **THERMOELECTRIC CONVERSION MATERIAL, COMPOSITION FOR THERMOELECTRIC CONVERSION MATERIAL, THERMOELECTRIC CONVERSION ELEMENT, THERMOELECTRIC CONVERSION MODULE, AND METHOD FOR MANUFACTURING THERMOELECTRIC CONVERSION MATERIAL**

(57)    A thermoelectric conversion material of the present disclosure contains Ge, Mg, at least one of Sb and Bi, and Te, and satisfies the condition (1) represented by $x + a + b < 0.98$. In the condition (1), $x$ is the amount-of-substance ratio of the content of Ge to the content of Te, $a$ is the amount-of-substance ratio of the content of Mg to the content of Te, and $b$ is the amount-of-substance ratio of the sum of the contents of Sb and Bi to the content of Te.

FIG. 2

EP 4 343 867 A1

**Description**

Technical Field

The present disclosure relates to a thermoelectric conversion material, a composition for thermoelectric conversion material, a thermoelectric conversion element, and a thermoelectric conversion module, and to a method for producing a thermoelectric conversion material.

Background Art

Thermoelectric conversion materials containing Ge and Te are conventionally known.
For example, Non Patent Literature 1 evaluates characteristics of materials having a composition $Ge_{0.95-x}Mg_{0.05}Sb_xTe$ in which x is 0, 0.05, 0.075, or 0.1.
Non Patent Literature 2 evaluates characteristics of samples having a composition $Ge_{0.96-x}Mn_xBi_{0.04}Te$ in which x is 0, 0.05, 0.1, 0.15, 0.2, or 0.3.

Citation List

Non Patent Literature

NPL 1: T. Xing et al., "Superior performance and high service stability for GeTe-based thermoelectric compounds", National Science Review, Vol. 6, Issue 5, pp. 944-954 (2019) [DOI: 10.1093/nsr/nwz052].
NPL 2: Z. Liu et al., "Phase-transition temperature suppression to achieve cubic GeTe and high thermoelectric performance by Bi and Mn cooping", Proceedings of the National Academy of Sciences of the United States of America, Vol. 115, Issue 21, pp. 5332-5337 (2018) [DOI: 10.1073/pnas.1802020115].

Summary of Invention

Technical Problem

The present disclosure provides a novel thermoelectric conversion material.

Solution to Problem

A thermoelectric conversion material of the present disclosure contains:

Ge, Mg, at least one of Sb or Bi, and Te, wherein
a condition (1) represented by x + a + b < 0.98 is satisfied,
where
x is an amount-of-substance ratio of a content of Ge to a content of Te,
a is an amount-of-substance ratio of a content of Mg to the content of Te, and
b is an amount-of-substance ratio of a sum of contents of Sb and Bi to the content of Te.

Advantageous Effects of Invention

According to the present disclosure, a novel thermoelectric conversion material can be provided.

Brief Description of Drawings

[Fig. 1] Fig. 1 is a schematic view of a NaCl-type crystal structure.
[Fig. 2] Fig. 2 is a schematic view illustrating an example of thermoelectric conversion elements and an example of thermoelectric conversion modules of the present disclosure.
[Fig. 3A] Fig. 3A is a photograph illustrating a thermoelectric conversion material according to EXAMPLE 1.
[Fig. 3B] Fig. 3B is a photograph illustrating a thermoelectric conversion material according to COMPARATIVE EXAMPLE 1.

[Fig. 4] Fig. 4 is a photograph illustrating the direction in which thermoelectric conversion materials according to EXAMPLES are cut.

[Fig. 5] Fig. 5 is a view schematically illustrating a three-point bending test.

[Fig. 6] Fig. 6 is a graph illustrating relationships between the breaking stress and the Ge content determined from results of a three-point bending test.

[Fig. 7A] Fig. 7A is a graph illustrating an X-ray diffraction (XRD) pattern of a thermoelectric conversion material according to EXAMPLE 1.

[Fig. 7B] Fig. 7B is a graph illustrating an XRD pattern of a thermoelectric conversion material according to COMPARATIVE EXAMPLE 1.

[Fig. 7C] Fig. 7C is a graph illustrating simulation results of an XRD pattern of GeTe having a crystal structure belonging to the space group Fm-3m.

[Fig. 8A] Fig. 8A is a backscattered electron image of the surface of the thermoelectric conversion material according to EXAMPLE 1 obtained with a scanning electron microscope (SEM).

[Fig. 8B] Fig. 8B is a characteristic X-ray intensity mapping image of elemental Ge obtained by energy dispersive X-ray spectroscopy (EDX) of the surface of the thermoelectric conversion material according to EXAMPLE 1.

[Fig. 9A] Fig. 9A is a backscattered electron image of the surface of the thermoelectric conversion material according to COMPARATIVE EXAMPLE 1 obtained with a SEM.

[Fig. 9B] Fig. 9B is a characteristic X-ray intensity mapping image of elemental Ge obtained by EDX of the surface of the thermoelectric conversion material according to COMPARATIVE EXAMPLE 1.

Description of Embodiments

(Underlying Knowledge Forming Basis of the Present Disclosure)

In the manufacturing of thermoelectric conversion elements from a thermoelectric conversion material, a plurality of thermoelectric converters are often obtained by cutting a mass including a thermoelectric conversion material. For example, the mass including a thermoelectric conversion material is a sintered body.

The materials of Non Patent Literature 1 are synthesized in the following manner. A mixture of Ge, Te, Sb, and Mg is heated slowly to 1373 K over 11 hours, heated at the temperature for 12 hours, and quenched with ice water. Subsequently, annealing is performed at 873 K for 5 days to provide an ingot. The provided ingot is pulverized into fine particles in an agate mortar. Subsequently, the particles are formed into a dense bulk sample by spark plasma sintering (SPS).

The synthesis of the materials in Non Patent Literature 1 requires annealing treatment before SPS, and the operation for producing the powder for SPS is complicated. In addition, the synthesis of the materials takes as long as about 6 days.

On the other hand, the samples in Non Patent Literature 2 are synthesized in the following manner. Raw materials are obtained by weighing Ge discs, Mn discs, Bi chunks, and Te chunks to the nominal composition $Ge_{0.96-x}Mn_xBi_{0.04}Te$. The raw materials are placed into a stainless-steel jar inside an argon atmosphere glove box. Subsequently, the raw materials are ball milled for 5 hours to provide a powder. The powder is added into a die and is hot-pressed for 2 minutes at a temperature of 773 K and a pressure of 90 MPa to provide a sample.

It is understood that in the synthesis of the samples in Non Patent Literature 2, crystallization occurs when the ball milled powder is sintered during hot pressing. According to the synthesis of the samples in Non Patent Literature 2, powder preparation is simple and a thermoelectric conversion material can be obtained in several hours.

The present inventors made an attempt in which a thermoelectric conversion material containing Ge, Mg, Sb, and Te was synthesized in accordance with the sample synthesis method of Non Patent Literature 2, and the thermoelectric conversion material was processed to produce a thermoelectric conversion element. However, the present inventors have newly found that the sintered body is cracked in the recovery of the sintered body including the thermoelectric conversion material or in the process of cutting the sintered body including the thermoelectric conversion material. Cracking of sintered bodies can lead to a low yield in the manufacturing of thermoelectric conversion elements. Sintered bodies that are prone to cracking, even if not cracked during the cutting process, may exhibit low durability against stress, such as thermal stress, applied during the use of thermoelectric conversion elements. When sintered bodies are prone to cracking, it will be also true that the compaction of the thermoelectric conversion material is difficult.

The present inventors then carried out further studies on the cause of cracking of sintered bodies and have newly found that a sintered body is cracked easily when the sintered body contains a large number of elemental Ge grains as impurities. Based on the newly found knowledge, the present inventors focused on the content of Ge in a thermoelectric conversion material containing Ge, Mg, Sb, and Te, and have developed a sintered body less prone to cracking as a novel thermoelectric conversion material.

(Embodiments of the Present Disclosure)

Hereinafter, embodiments of the present disclosure will be described with reference to the drawings.

A thermoelectric conversion material of the present disclosure contains Ge, Mg, at least one of Sb or Bi, and Te. The thermoelectric conversion material satisfies the condition (1) represented by $x + a + b < 0.98$. In the condition (1), x is the amount-of-substance ratio of the content of Ge to the content of Te, a is the amount-of-substance ratio of the content of Mg to the content of Te, and b is the amount-of-substance ratio of the sum of the contents of Sb and Bi to the content of Te. For example, the contents of Ge, Mg, Sb, Bi, and Te in the thermoelectric conversion material may be determined by inductively coupled plasma (ICP) emission spectrometry.

The thermoelectric conversion material easily attains a desired thermoelectric conversion performance by containing Mg and at least one of Sb or Bi in addition to Ge and Te. Furthermore, by virtue of the thermoelectric conversion material satisfying the condition (1), the amount of elemental Ge grains present in the thermoelectric conversion material is small and a sintered body including the thermoelectric conversion material is unlikely to crack. Thus, the use of the thermoelectric conversion material facilitates increasing the yield of thermoelectric conversion elements and by extension the yield of thermoelectric conversion modules. In addition, a sintered body including the thermoelectric conversion material is unlikely to crack even when subjected to stress, such as thermal stress, during the use of a thermoelectric conversion element and by extension the use of a thermoelectric conversion module. As a result, the durability of the thermoelectric conversion element and the thermoelectric conversion module tends to be increased.

The thermoelectric conversion material may satisfy the condition $x + a + b \leq 0.97$, may satisfy the condition $x + a + b \leq 0.96$, or may satisfy the condition $x + a + b \leq 0.95$.

For example, the thermoelectric conversion material satisfies the condition (2) represented by $x + a + b > 0.65$. In this case, the thermoelectric conversion material tends to have desired strength more reliably.

The thermoelectric conversion material may satisfy the condition $x + a + b \geq 0.66$, may satisfy the condition $x + a + b \geq 0.67$, or may satisfy the condition $x + a + b \geq 0.68$.

For example, the thermoelectric conversion material satisfies the condition (3) represented by $0.65 \leq x < 0.83$.

The thermoelectric conversion material may satisfy the condition $x \leq 0.82$, may satisfy the condition $x \leq 0.81$, may satisfy the condition $x \leq 0.80$, may satisfy the condition $x \leq 0.79$, or may satisfy the condition $x \leq 0.78$.

The thermoelectric conversion material may satisfy the condition $x \geq 0.66$, may satisfy the condition $x \geq 0.67$, may satisfy the condition $x \geq 0.68$, or may satisfy the condition $x \geq 0.69$.

For example, the thermoelectric conversion material has a composition represented by $Ge_xMg_aSb_bTe$. In the composition, the value of x is in the range of greater than or equal to 0.65 and less than 0.83, the value of a is in the range of greater than 0 and less than or equal to 0.07, and the value of b is in the range of greater than 0 and less than or equal to 0.20. In other words, the composition satisfies the conditions $0.65 \leq x < 0.83$, $0 < a \leq 0.07$, and $0 < b \leq 0.20$. In this case, the thermoelectric conversion material tends to have desired strength more reliably.

For example, the thermoelectric conversion material has a composition represented by $Ge_xMg_aSb_bBi_{d-b}Te$. In the composition, the value of x is in the range of greater than or equal to 0.65 and less than 0.83, the value of a is in the range of greater than 0 and less than or equal to 0.07, the value of b is in the range of greater than 0 and less than or equal to 0.20, and the value of d is in the range of greater than or equal to 0 and less than or equal to b. In other words, the composition satisfies the conditions $0.65 \leq x < 0.83$, $0 < a \leq 0.07$, $0 < b \leq 0.20$, and $0 \leq d \leq b$. In this case, the thermoelectric conversion material tends to have desired strength more reliably.

In the above composition, the value of x may be less than or equal to 0.82, may be less than or equal to 0.81, may be less than or equal to 0.80, may be less than or equal to 0.79, or may be less than or equal to 0.78. In other words, the composition may satisfy the condition $x \leq 0.82$, may satisfy the condition $x \leq 0.81$, may satisfy the condition $x \leq 0.80$, may satisfy the condition $x \leq 0.79$, or may satisfy the condition $x \leq 0.78$.

In the above composition, the value of x may be greater than or equal to 0.66, may be greater than or equal to 0.67, may be greater than or equal to 0.68, or may be greater than or equal to 0.69. In other words, the composition may satisfy the condition $x \geq 0.66$, may satisfy the condition $x \geq 0.67$, may satisfy the condition $x \geq 0.68$, or may satisfy the condition $x \geq 0.69$.

In the above composition, the value of a may be greater than or equal to 0.01 and less than or equal to 0.07 or may be greater than or equal to 0.01 and less than or equal to 0.06. In other words, the composition may satisfy the condition $0.01 \leq a \leq 0.07$ or may satisfy the condition $0.01 \leq a \leq 0.06$.

The value of a is desirably greater than or equal to 0.02 and less than or equal to 0.06, more desirably greater than or equal to 0.03 and less than or equal to 0.06, and still more desirably greater than or equal to 0.04 and less than or equal to 0.06. The value of a is particularly desirably greater than or equal to 0.05 and less than or equal to 0.06. In other words, the composition desirably satisfies the condition $0.02 \leq a \leq 0.06$, more desirably satisfies the condition $0.03 \leq a \leq 0.06$, still more desirably satisfies the condition $0.04 \leq a \leq 0.06$, and particularly desirably satisfies the condition $0.05 \leq a \leq 0.06$.

In the above composition, the value of b may be greater than or equal to 0.01, may be greater than or equal to 0.02, or may be greater than or equal to 0.03. In other words, the composition may satisfy the condition b ≥ 0.01 or may satisfy the condition b ≥ 0.02.

The value of b may be less than or equal to 0.19, may be less than or equal to 0.18, or may be less than or equal to 0.17. In other words, the composition may satisfy the condition b ≤ 0.18 or may satisfy the condition b ≤ 0.17.

The value of b is desirably greater than or equal to 0.04 and less than or equal to 0.16, more desirably greater than or equal to 0.06 and less than or equal to 0.15, still more desirably greater than or equal to 0.08 and less than or equal to 0.14, and further desirably greater than or equal to 0.09 and less than or equal to 0.13.

The value of b is particularly desirably greater than or equal to 0.10 and less than or equal to 0.11. In other words, the composition desirably satisfies the condition $0.04 \leq b \leq 0.16$, more desirably satisfies the condition $0.06 \leq b \leq 0.15$, still more desirably satisfies the condition $0.08 \leq b \leq 0.14$, further desirably satisfies the condition $0.09 \leq b \leq 0.13$, and particularly desirably satisfies the condition $0.10 \leq b \leq 0.11$.

The crystal structure of the thermoelectric conversion material is not limited to any particular crystal structure. For example, the crystal structure is a NaCl-type crystal structure. In this case, a sintered body including the thermoelectric conversion material is more unlikely to crack and the thermoelectric conversion material tends to exhibit a desired thermoelectric conversion performance more reliably. For example, the crystal structure of the thermoelectric conversion material may be determined by analysis based on X-ray diffractometry (XRD).

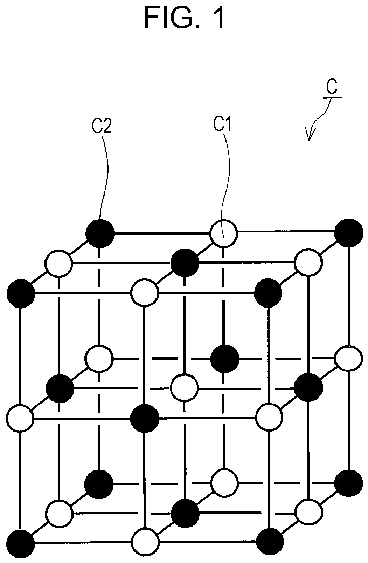

Fig. 1 schematically illustrates a NaCl-type crystal structure. In Fig. 1, C1 indicates a Na site and C2 indicates a Cl site. The thermoelectric conversion material may be such that Ge, Mg, or Sb is located at the Na sites, and Te is located at the Cl sites. In the thermoelectric conversion material, all the sites in the crystal structure are not necessarily filled and the crystal structure may contain lattice defects, such as vacancies.

For example, the thermoelectric conversion material is a polycrystal. A sintered body including such a thermoelectric conversion material is more unlikely to crack.

When the thermoelectric conversion material is a polycrystal, the polycrystal includes, for example, crystal grains having a NaCl-type crystal structure. A sintered body including such a thermoelectric conversion material is more unlikely to crack, and the thermoelectric conversion material tends to exhibit a desired thermoelectric conversion performance more reliably. For example, the crystal grains may be identified by observing the surface or a cross section of the thermoelectric conversion material with a scanning electron microscope (SEM). Prior to SEM observation, the surface or the cross section of the thermoelectric conversion material may be polished.

The crystal structure of the thermoelectric conversion material may belong to any space group without limitation. For example, the crystal structure of the thermoelectric conversion material belongs to at least one selected from the group consisting of space group Fm-3m and space group R-3m.

The breaking stress BS of the thermoelectric conversion material is not limited to any particular value. For example, the thermoelectric conversion material satisfies the condition (4): $16.0 \text{ N/mm}^2 \leq BS \leq 5000 \text{ N/mm}^2$. In the condition (4), BS indicates the breaking stress BS of the thermoelectric conversion material.

The breaking stress BS of the thermoelectric conversion material may be typically determined by a three-point bending test. The three-point bending test is performed using a three-point bending test specimen prepared from the thermoelectric conversion material. The breaking load of the test specimen in the test is divided by the area of the broken face of the test specimen to determine the breaking stress of the thermoelectric conversion material. The shape and the size of the test specimen may be determined in consideration of the ease of calculating the area of the broken face, the distance between the supports, and the effort. For example, the test specimen is a rectangular solid.

Desirably, two or more test specimens of the thermoelectric conversion material are subjected to the three-point bending test. For example, the three-point bending test is performed in a 25°C environment. For example, the three-point bending test may be carried out with a tester conforming to Japanese Industrial Standards JIS B7721 Class 1, ISO 7500-1 Class 1, EN10002-2 Grade 1, or ASTM E4.

When the thermoelectric conversion material satisfies the condition (4), the strength of the thermoelectric conversion material is high and, for example, a sintered body including the thermoelectric conversion material is easily processed by cutting.

The thermoelectric conversion material desirably has a breaking stress BS of greater than or equal to 20 N/mm². In other words, the thermoelectric conversion material desirably satisfies the condition $BS \geq 20 \text{ N/mm}^2$. For example, the breaking stress BS of the thermoelectric conversion material is less than or equal to 5000 N/mm². In other words, for example, the thermoelectric conversion material satisfies the condition $BS \leq 5000 \text{ N/mm}^2$.

The breaking stress BS of the thermoelectric conversion material may be less than or equal to 4000 N/mm², may be less than or equal to 3000 N/mm², may be less than or equal to 2000 N/mm², may be less than or equal to 1000 N/mm², may be less than or equal to 500 N/mm², or may be less than or equal to 200 N/mm². In other words, the thermoelectric conversion material may satisfy the condition $BS \leq 4000 \text{ N/mm}^2$, may satisfy the condition $BS \leq 3000 \text{ N/mm}^2$, may satisfy the condition $BS \leq 2000 \text{ N/mm}^2$, may satisfy the condition $BS \leq 1000 \text{ N/mm}^2$, may satisfy the condition $BS \leq 500 \text{ N/mm}^2$, or may satisfy the condition $BS \leq 200 \text{ N/mm}^2$.

For example, the ratio Sg/St is less than 1.1% wherein St is the area of a predetermined face of the thermoelectric conversion material and Sg is the area of an elemental Ge phase in the predetermined face. In this case, a sintered body including the thermoelectric conversion material is more unlikely to crack. The ratio Sg/St is desirably less than or equal to 1.0%, more desirably less than or equal to 0.8%, still more desirably less than or equal to 0.5%, further desirably less than or equal to 0.2%, and particularly desirably less than or equal to 0.0%. For example, the ratio Sg/St may be determined by SEM-EDX that combines SEM with energy dispersive X-ray spectroscopy (EDX).

An exemplary method for determining the ratio Sg/St will be described. First, an enlarged observation image is obtained by SEM for the evaluation of a predetermined face of the thermoelectric conversion material. Next, Ge, Mg, Sb, and Te elements in the enlarged observation image are selectively quantified by EDX. Since the content of Mg in the thermoelectric conversion material is low, Mg may be excluded from the elements that are selected. On the other hand, C, O, and Al may attach as impurities to the surface of the thermoelectric conversion material, and thus these elements may be added to the elements that are selected. Next, the concentrations based on the number of atoms of the quantified three elements, namely, Ge, Sb, and Te, are converted into intensities and mapped on the image. In this mapping, the elements are assigned different colors. For example, red (R) is assigned to Ge, green (G) is assigned to Sb, and blue (B) is assigned to Te. Next, a threshold is set for the purity of the color assigned to Ge, and regions that have a purity higher than or equal to the threshold are emphasized in the mapping image. An evaluation image is thus obtained. Alternatively, an evaluation image may be obtained by converting the mapping image into a black and white binarized image in which white is assigned only to regions having a purity higher than or equal to the threshold. The area of the whole of the evaluation image corresponds to the area St, and the area of the regions having a purity higher than or equal to the threshold in the evaluation image corresponds to the area Sg.

In an alternative process, a threshold may be set for the brightness corresponding to the amount of secondary electrons in the enlarged observation SEM image for the evaluation of the predetermined face of the thermoelectric conversion material, and the ratio Sg/St may be determined assuming that the area of regions as bright as or less bright than the threshold corresponds to the area Sg.

The thermoelectric conversion material may be produced by any method without limitation. For example, the thermoelectric conversion material is produced by a method that includes energizing an alloy powder containing Ge, Mg, at least one of Sb or Bi, and Te by spark plasma sintering (SPS), and sintering the alloy powder at a temperature higher than or equal to 500°C. For example, the alloy powder is a polycrystalline powder. In SPS, for example, the alloy powder is charged into a die made of carbon. During the sintering, a predetermined pressure is applied to the alloy powder. For example, the magnitude of the pressure is 10 MPa to 100 MPa. For example, the sintering temperature for the alloy powder being sintered is lower than or equal to 700°C. The energization time during the sintering of the alloy powder is not limited to any particular value. For example, the energization time is 2 minutes to 1 hour.

For example, the alloy powder is obtained as an alloy powder composition for thermoelectric conversion material. For example, the composition for thermoelectric conversion material is produced by the following method.

First, elemental Ge, elemental Mg, elemental Sb, elemental Bi, and elemental Te are weighed in an inert gas atmosphere. The elemental Ge, the elemental Mg, the elemental Sb, the elemental Bi, and the elemental Te as the weighed raw materials are sealed in a container made of stainless steel. The raw materials sealed in the container made of stainless steel are pulverized and mixed using an ambient pulverizer to provide an alloy powder as a composition for thermoelectric conversion material.

The composition for thermoelectric conversion material contains Ge, Mg, at least one of Sb or Bi, and Te, and satisfies the condition (5) represented by $x + a + b < 1.0$. In the condition (5), $x$ is the amount-of-substance ratio of the content of Ge to the content of Te; $a$ is the amount-of-substance ratio of the content of Mg to the content of Te; and $b$ is the amount-of-substance ratio of the sum of the contents of Sb and Bi to the content of Te.

The composition for thermoelectric conversion material may satisfy the condition $x + a + b \leq 0.99$, may satisfy the condition $x + a + b \leq 0.98$, or may satisfy the condition $x + a + b \leq 0.97$.

The composition for thermoelectric conversion material may satisfy the condition $x + a + b > 0.65$, may satisfy the condition $x + a + b \geq 0.66$, may satisfy the condition $x + a + b \geq 0.67$, or may satisfy the condition $x + a + b \geq 0.68$.

The composition for thermoelectric conversion material may satisfy the condition $0.65 \leq x < 0.83$, may satisfy the condition $x \leq 0.82$, may satisfy the condition $x \leq 0.81$, may satisfy the condition $x \leq 0.80$, may satisfy the condition $x \leq 0.79$, or may satisfy the condition $x \leq 0.78$.

The composition for thermoelectric conversion material may satisfy the condition $x \geq 0.66$, may satisfy the condition $x \geq 0.67$, may satisfy the condition $x \geq 0.68$, or may satisfy the condition $x \geq 0.69$.

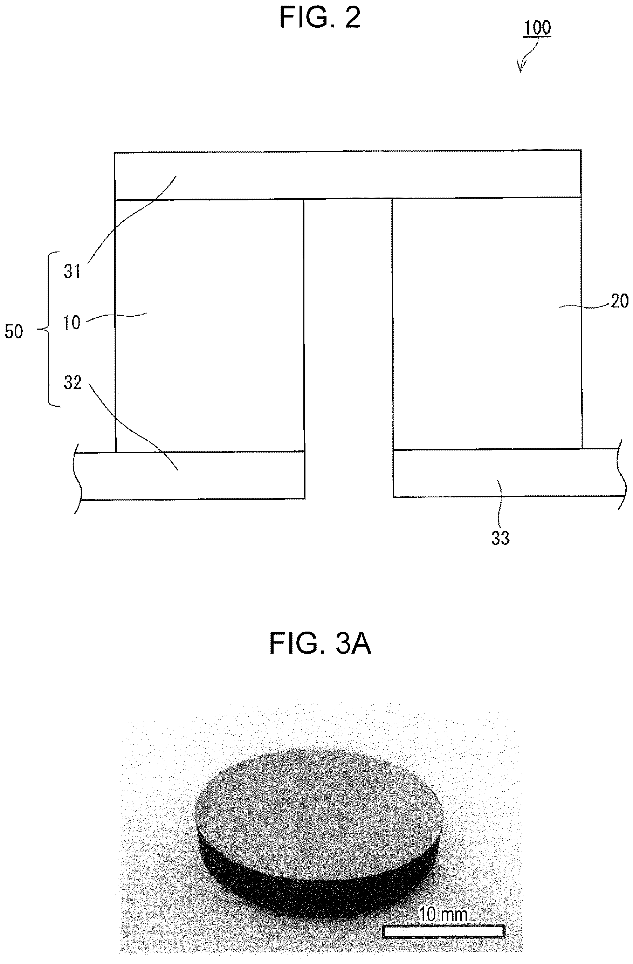

The use of the thermoelectric conversion material of the present disclosure can provide a thermoelectric conversion element and by extension can provide a thermoelectric conversion module. Fig. 2 illustrates an example of the thermoelectric conversion elements and an example of the thermoelectric conversion modules.

As illustrated in Fig. 2, a thermoelectric conversion element 50 includes a thermoelectric converter 10, a first electrode 31, and a second electrode 32. The first electrode 31 is electrically connected to a first end at the thermoelectric converter 10. The second electrode 32 is electrically connected to a second end at the thermoelectric converter 10. In other words, the first electrode 31 is electrically connected to one end of the thermoelectric converter 10, and the second electrode 32 is electrically connected to the other end of the thermoelectric converter 10. The thermoelectric converter 10 includes the thermoelectric conversion material described hereinabove. Thus, the thermoelectric converter 10 is unlikely to crack even when stress, such as thermal stress, occurs in the thermoelectric converter 10 during the use of the thermoelectric conversion element 50, and the thermoelectric conversion element 50 tends to exhibit high durability.

For example, as illustrated in Fig. 2, the thermoelectric converter 10 in a thermoelectric conversion module 100 is a p-type thermoelectric converter. For example, the thermoelectric conversion module 100 includes a p-type thermoelectric converter 10, an n-type thermoelectric converter 20, a first electrode 31, a second electrode 32, and a third electrode 33. The first electrode 31 electrically connects a first end at the p-type thermoelectric converter 10 to a third end at the n-type thermoelectric converter 20. The second electrode 32 is electrically connected to a second end at the p-type thermoelectric converter 10. The third electrode 33 is electrically connected to a fourth end at the n-type thermoelectric converter 20. In other words, the first electrode 31 electrically connects one end of the p-type thermoelectric converter 10 to one end of the n-type thermoelectric converter 20; the second electrode 32 is electrically connected to the other end of the p-type thermoelectric converter 10; and the third electrode 33 is electrically connected to the other end of the n-type thermoelectric converter 20.

For example, in the thermoelectric conversion module 100, one end of the p-type thermoelectric converter 10 and one end of the n-type thermoelectric converter 20 are located on the same side in a specific direction. When, for example, a temperature variation occurs between that one end and the other end of the p-type thermoelectric converter 10, a thermoelectromotive force is generated in the p-type thermoelectric converter 10. When, in addition, a temperature variation occurs between that one end and the other end of the n-type thermoelectric converter 20, a thermoelectromotive force is generated in the n-type thermoelectric converter 20. In this manner, the thermoelectric conversion module 100 can generate power.

By allowing a current to flow in the thermoelectric conversion module 100, for example, heat is transferred from that one end to the other end of the p-type thermoelectric converter 10, and heat is transferred from that one end to the other end of the n-type thermoelectric converter 20. By causing a current to flow in the reverse direction in the thermoelectric conversion module 100, heat is transferred from the other end to that one end of the p-type thermoelectric converter 10, and heat is transferred from the other end to that one end of the n-type thermoelectric converter 20.

EXAMPLES

The present disclosure will be described in detail hereinbelow with reference to EXAMPLES. However, the thermoelectric conversion materials of the present disclosure are not limited to those specific embodiments described below.

(EXAMPLE 1)

In an argon atmosphere glove box, granular Ge, granular Mg, granular Sb, and granular Te were weighed out. The mass and the amount of substance of granular Ge were 2.399 g and 0.033 mol, respectively. The mass and the amount of substance of granular Mg were 0.051 g and 0.0021 mol, respectively. The mass and the amount of substance of granular Sb were 0.503 g and 0.0041 mol, respectively. The mass and the amount of substance of granular Te were 5.271 g and 0.041 mol, respectively. The molar ratio of Ge, Mg, Sb, and Te in the starting materials of EXAMPLE 1 were in the relationship of Ge:Mg:Sb:Te = 0.80:0.05:0.1:1. The Ge, Mg, Sb, and Te that were weighed out were added to a stainless-steel ball mill container together with stainless-steel balls. The stainless-steel balls included two balls with a diameter of 10 mm and one ball with a diameter of 5 mm. The internal volume of the ball mill container was 65 milliliters (mL).

Using ambient pulverizer 8000D Mixer/Mill from SPEX SamplePrep., the starting materials in the ball mill container including Ge, Mg, Sb, and Te were pulverized and mixed for 2 hours. A mixed powder of Ge, Mg, Sb, and Te was thus obtained.

The mixed powder was sintered by spark plasma sintering (SPS). Approximately 2.0 g of the mixed powder was charged into a cylindrical die made of carbon. The outer diameter of the die was 50 mm and the inner diameter of the die was 10 mm. Next, the mixed powder charged in the die was electrically heated while applying pressure. The mixed powder was thus sintered. The pressure applied to the mixed powder during the sintering was 60 MPa, and the sintering temperature was 550°C. Thus, a dense sintered body was obtained as a thermoelectric conversion material according to EXAMPLE 1.

(EXAMPLES 2 to 4 and COMPARATIVE EXAMPLE 1)

Thermoelectric conversion materials according to EXAMPLES 2 to 4 and COMPARATIVE EXAMPLE 1 were produced in the same manner as in EXAMPLE 1, except that the molar ratio of Ge, Mg, Sb, and Te in the starting materials was changed as described in Table 1.

[Analysis of Composition of Thermoelectric Conversion Materials]

Samples prepared from the thermoelectric conversion materials were analyzed by ICP emission spectroscopy. Based on the results of the analysis, the molar ratio of Ge, Mg, Sb, and Te in each of the thermoelectric conversion materials was determined, thereby determining the composition of each thermoelectric conversion material. The results are described in Table 1. The molar ratios of Ge, Mg, Sb, and Te in the thermoelectric conversion materials were approximately the same as the molar ratios of Ge, Mg, Sb, and Te in the respective starting materials for the thermoelectric conversion materials.

[Evaluation of Thermoelectric Characteristics]

The thermoelectric conversion materials were each analyzed with thermoelectric evaluation system ZEM-3 manufactured by ADVANCE RIKO, Inc. to measure the Seebeck coefficient Q and the electrical conductivity $\sigma$ at 400°C. Based on the measurement results, the power factor P of the thermoelectric conversion material at 400°C was determined from the relationship $P = Q^2\sigma$. The results are described in Table 1. The power factor P is an index for evaluating thermoelectric characteristics of thermoelectric conversion materials and corresponds to the amount of power generated per temperature variation in the thermoelectric conversion material. A thermoelectric conversion material having a high power factor P can be evaluated as being capable of exhibiting an excellent thermoelectric conversion performance. Incidentally, the thermoelectric conversion materials had a high power factor P in the temperature range of 25°C to 500°C.

[Table 1]

| | Starting materials molar ratio Ge:Mg:Sb:Te | Composition of thermoelectric conversion material | Power factor P at 400°C $(mW/(m \cdot K^2))$ |
|---|---|---|---|
| EX.1 | 0.80:0.05:0.1:1 | $Ge_{0.78}Mg_{0.05}Sb_{0.10}Te_1$ | 3.42 |
| EX.2 | 0.75:0.05:0.1:1 | $Ge_{0.74}Mg_{0.05}Sb_{0.10}Te_1$ | 2.41 |
| EX.3 | 0.70:0.05:0.1:1 | $Ge_{0.73}Mg_{0.06}Sb_{0.11}Te_1$ | 1.66 |
| EX.4 | 0.65:0.05:0.1:1 | $Ge_{0.69}Mg_{0.06}Sb_{0.11}Te_1$ | 1.17 |
| COMP. EX.1 | 0.85:0.05:0.1:1 | $Ge_{0.83}Mg_{0.05}Sb_{0.10}Te_1$ | 2.56 |

[Cutting]

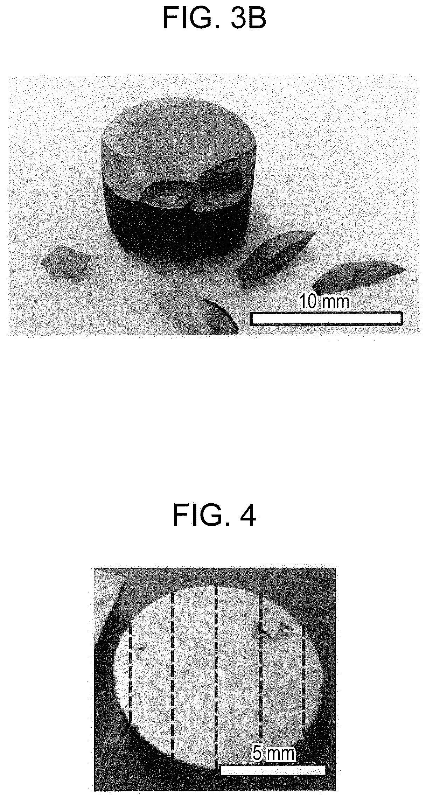

The thermoelectric conversion materials according to EXAMPLES 1 to 4 and COMPARATIVE EXAMPLE 1 were ejected from the cylindrical die by pressing with a hydraulic press. Fig. 3A is a photograph illustrating the thermoelectric conversion material according to EXAMPLE 1 ejected from the die. The thermoelectric conversion materials according to EXAMPLES 1 to 4 were not broken when being ejected from the die. Fig. 3B is a photograph illustrating the thermoelectric conversion material according to COMPARATIVE EXAMPLE 1 ejected from the die. As illustrated in Fig. 3B, the thermoelectric conversion material according to COMPARATIVE EXAMPLE 1 suffered linear cracks or hexagonal cracks on the surface and was broken when the thermoelectric conversion material was ejected from the die.

The thermoelectric conversion materials according to EXAMPLES were each cut with precision cutting machine IsoMet Low Speed Saw. Fig. 4 is a photograph illustrating the direction in which the thermoelectric conversion materials according to EXAMPLES were cut in the cutting process. The thermoelectric conversion materials according to EXAMPLES were not broken in the cutting process.

[Three-Point Bending Test]

The thermoelectric conversion materials according to EXAMPLES were each cut into a rectangular solid having a length of greater than or equal to 4 mm, a thickness of about 2 mm, and a width of about 2 mm. Test specimens for a three-point bending test were thus prepared. Furthermore, a broken piece of the thermoelectric conversion material according to COMPARATIVE EXAMPLE 1 was cut to provide test specimens for a three-point bending test.

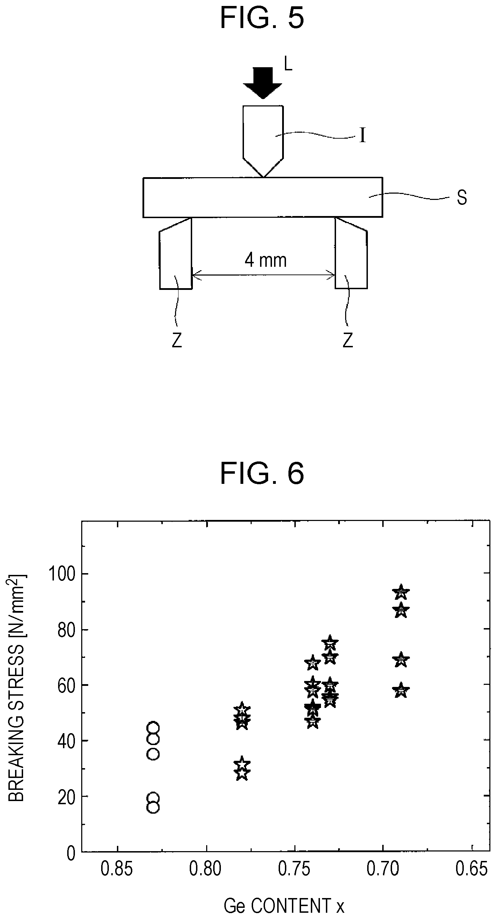

Fig. 5 is a view schematically illustrating a three-point bending test. As illustrated in Fig. 5, the test specimen S was placed on a pair of jigs Z with a distance between the supports adjusted to 4 mm, and an indenter I was pressed against the test specimen S to apply a load L. The three-point bending test was performed in a 25°C environment. The three-point bending test involved testing machine EZ-Test manufactured by Shimadzu Corporation, and the test speed was set to 0.5 mm/min. In the three-point bending test, the maximum load [N] recorded immediately before the test specimen was broken was taken as the breaking load, and the breaking load was divided by the area of the broken face of the test specimen to calculate the breaking stress [N/mm$^2$]. The three-point bending test was performed 4 or more times on each of the thermoelectric conversion materials.

Fig. 6 is a graph illustrating relationships between the breaking stress and the Ge content determined from the results of the three-point bending test. The Ge content x on the abscissa in Fig. 6 is the ratio of the amount of substance of Ge to the amount of substance of Te in the thermoelectric conversion material. The minimum values of the breaking stress of the thermoelectric conversion materials are described in Table 2.

As illustrated in Fig. 6, it is understood that the breaking stress tends to be higher with decreasing Ge content x in the thermoelectric conversion material. It is also understood that the breaking stress of the thermoelectric conversion material according to COMPARATIVE EXAMPLE 1 tends to be lower than the breaking stress of the thermoelectric conversion materials according to EXAMPLES 1 to 4.

It is probable that the thermoelectric conversion material according to COMPARATIVE EXAMPLE 1 was prone to breakage due to the pressure applied to eject the thermoelectric conversion material from the die at or below a certain threshold of the breaking stress of the thermoelectric conversion material. Thus, the minimum value of the breaking stress of the thermoelectric conversion material can be regarded as an index that determines whether or not the thermoelectric conversion material will be broken. As described in Table 2, the minimum value of the breaking stress of the thermoelectric conversion material according to COMPARATIVE EXAMPLE 1 is 16 N/mm$^2$, which is lower than the minimum value of the breaking stress of the thermoelectric conversion material according to any of EXAMPLES 1 to 4. In other words, the three-point bending test specimens prepared from the broken piece of the thermoelectric conversion material according to COMPARATIVE EXAMPLE 1 can be evaluated as having a minimum value of the breaking stress of 16 N/mm$^2$. On the other hand, it is assumed that the breaking stress of the pieces of the thermoelectric conversion material that could not withstand the processing for the preparation of the three-point bending test specimens is less than 16 N/mm$^2$. Thus, the results indicated that a breaking stress of the thermoelectric conversion material greater than or equal to 16 N/mm$^2$ is advantageous from the point of view of the ease of cutting.

[Analysis of Crystal Structures]

Samples prepared from the thermoelectric conversion materials according to EXAMPLES 1 to 4 and COMPARATIVE EXAMPLE 1 were subjected to XRD analysis. The XRD analysis involved X-ray diffractometer Aeris manufactured by Malvern Panalytical Ltd. and used Cu-K$\alpha$ radiation as X-ray.

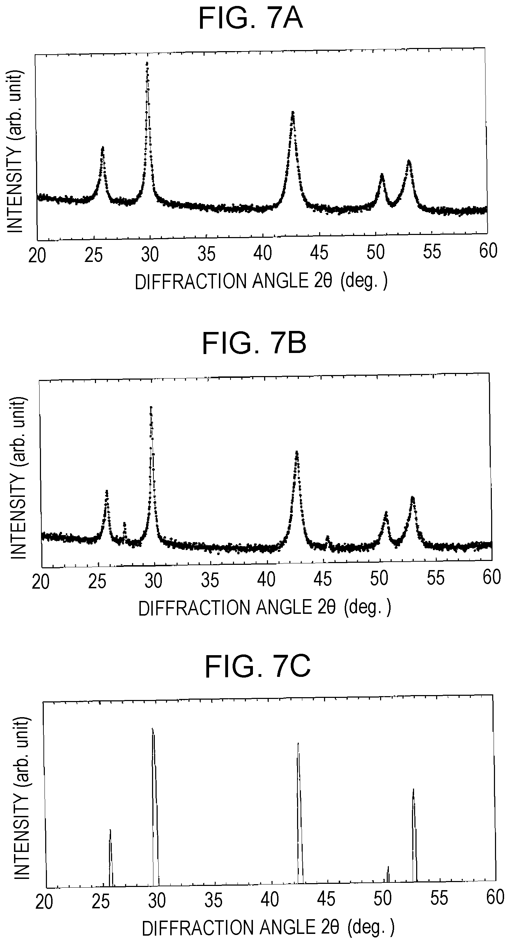

Fig. 7A is a graph illustrating the XRD pattern of the thermoelectric conversion material according to EXAMPLE 1. Fig. 7C illustrates simulation results of an XRD pattern of GeTe having a crystal structure belonging to the space group Fm-3m. The crystal structure simulated in Fig. 7C is a cubic crystal structure having a lattice constant of 0.601 nanometers. The diffraction peaks in the XRD pattern of Fig. 7A agree with the diffraction peaks in the XRD pattern simulation results in Fig. 7C. Thus, the thermoelectric conversion material according to EXAMPLE 1 is understood as having a cubic crystal structure belonging to the space group Fm-3m. The XRD patterns of the thermoelectric conversion materials according to EXAMPLES 2 to 4 similarly showed diffraction peaks assigned to a cubic crystal structure. The XRD patterns of the thermoelectric conversion materials according to EXAMPLES had no diffraction peaks probably assigned to impurities other than the cubic crystal structure.

Fig. 7B is a graph illustrating the XRD pattern of the thermoelectric conversion material according to COMPARATIVE EXAMPLE 1. This XRD pattern contained diffraction peaks probably assigned to impurities other than the cubic crystal structure. The diffraction peaks probably assigned to impurities were confirmed to agree with diffraction peaks assigned to an elemental Ge crystal structure that is a diamond structure belonging to the space group Fd-3m.

[Observation of Elemental Ge Grains]

Samples prepared from the thermoelectric conversion materials according to EXAMPLES 1 to 4 and COMPARATIVE EXAMPLE 1 were subjected to SEM-EDX. SEM-EDX involved SEM SU8220 manufactured by Hitachi High-Tech Corporation.

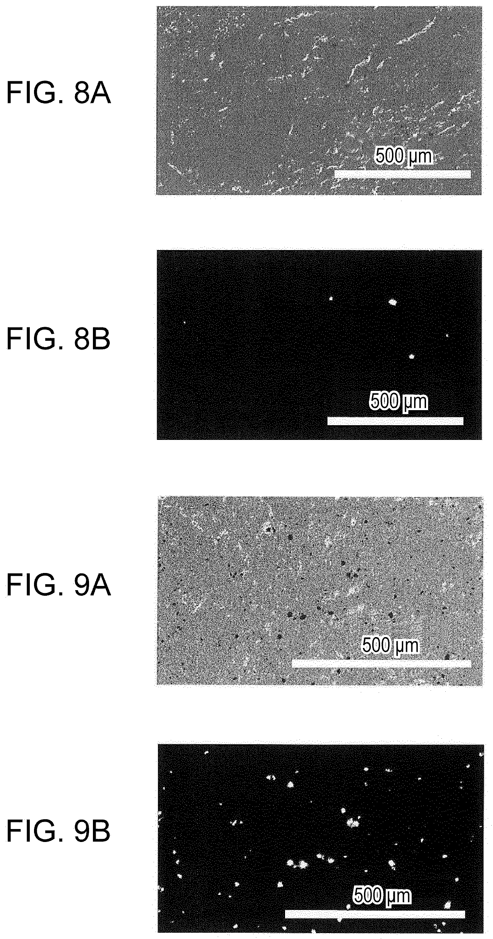

Fig. 8A is a backscattered electron image of the surface of the thermoelectric conversion material according to EXAMPLE 1 obtained by SEM. Fig. 8B is a characteristic X-ray intensity mapping image of elemental Ge obtained by EDX. The intensity of the characteristic X-ray L$\alpha$ of elemental Ge is 1.188 keV. As illustrated in Fig. 8B, elemental Ge was uniformly distributed throughout the thermoelectric conversion material according to EXAMPLE 1, and there were almost no elemental Ge grains. The same was true for the thermoelectric conversion materials according to other EXAMPLES.

Fig. 9A is a backscattered electron image of the surface of the thermoelectric conversion material according to COMPARATIVE EXAMPLE 1 obtained by SEM. Fig. 9B is a characteristic X-ray intensity mapping image of elemental Ge obtained by EDX of the surface of the thermoelectric conversion material according to COMPARATIVE EXAMPLE 1. As illustrated in Fig. 9B, unlike the thermoelectric conversion materials according to EXAMPLES 1 to 4, the thermoelectric conversion material according to COMPARATIVE EXAMPLE 1 was clearly shown to contain elemental Ge grains precipitated with a particle size of 1 to 20 $\mu$m.

In the elemental Ge characteristic X-ray intensity mapping image obtained by EDX of the surface of the thermoelectric conversion material according to each of EXAMPLES and COMPARATIVE EXAMPLE 1, the area Sg occupied by the elemental Ge grains was divided by the area St of the whole of the image, thereby calculating the ratio Sg/St. The results are described in Table 2. Table 2 also describes the molar ratio (Ge + Mg + Sb)/Te of the sum of the contents of Ge, Mg, Sb, and Te to the content of Te.

It is understood that a thermoelectric conversion material having a cubic crystal structure and containing no or little elemental Ge precipitates can be obtained by reducing the Ge content in the starting materials.

[Table 2]

| | Ratio of the amount of substance of Ge to the amount of substance of Te in the starting materials | (Ge+Mg+Sb)/Te | Minimum value of breaking stress (N/mm$^2$) | Ratio Sg/St (%) |
|---|---|---|---|---|
| EX.1 | 0.80 | 0.93 | 28.3 | 0.2 |
| EX.2 | 0.75 | 0.89 | 46.8 | 0.0 |
| EX.3 | 0.70 | 0.90 | 54.4 | 0.0 |
| EX.4 | 0.65 | 0.86 | 57.8 | 0.0 |
| COMP. EX.1 | 0.85 | 0.98 | 16.0 | 1.1 |

Industrial Applicability

The thermoelectric conversion material of the present disclosure may be used for a thermoelectric conversion element that converts thermal energy into electrical energy. Reference Signs List

10 thermoelectric converter (p-type thermoelectric converter)

20 n-type thermoelectric converter

31 first electrode

32 second electrode

33 third electrode

50 thermoelectric conversion element

100 thermoelectric conversion module

**Claims**

1. A thermoelectric conversion material comprising:

Ge, Mg, at least one of Sb and Bi, and Te,
the thermoelectric conversion material satisfying condition (1) represented by x + a + b < 0.98,
in the condition (1),
x is the amount-of-substance ratio of the content of Ge to the content of Te,
a is the amount-of-substance ratio of the content of Mg to the content of Te, and
b is the amount-of-substance ratio of the sum of the contents of Sb and Bi to the content of Te.

**2.** The thermoelectric conversion material according to claim 1, wherein
the thermoelectric conversion material satisfies condition (2) represented by x + a + b > 0.65.

**3.** The thermoelectric conversion material according to claim 1 or 2, wherein
the thermoelectric conversion material satisfies condition (3) represented by $0.65 \leq x < 0.83$.

**4.** The thermoelectric conversion material according to any one of claims 1 to 3, wherein
the thermoelectric conversion material has a NaCl-type crystal structure.

**5.** The thermoelectric conversion material according to claim 4, wherein
the crystal structure belongs to at least one selected from the group consisting of space group Fm-3m and space group R-3m.

**6.** The thermoelectric conversion material according to any one of claims 1 to 5, wherein
the thermoelectric conversion material is a polycrystal.

**7.** The thermoelectric conversion material according to claims 1 to 6, wherein

the thermoelectric conversion material has a composition represented by $Ge_xMg_aSb_bBi_{d-b}Te$ and
the composition satisfies conditions:

$$0.65 \leq x < 0.83, \ 0 < a \leq 0.07, \ 0 < b \leq 0.20, \text{ and } 0 \leq d \leq b.$$

**8.** The thermoelectric conversion material according to claim 7, wherein
the composition satisfies condition $0.02 \leq a \leq 0.06$.

**9.** The thermoelectric conversion material according to claim 7 or 8, wherein
the composition satisfies condition $0.04 \leq b \leq 0.16$.

**10.** The thermoelectric conversion material according to any one of claims 1 to 9, wherein

the thermoelectric conversion material satisfies condition (4): $16.0 \text{ N/mm}^2 \leq BS \leq 5000 \text{ N/mm}^2$,
in the condition (4), BS indicates the breaking stress of the thermoelectric conversion material.

**11.** The thermoelectric conversion material according to any one of claims 1 to 10, wherein
the ratio of the area of an elemental Ge phase in a predetermined face of the thermoelectric conversion material is less than 1.1% relative to the area of the predetermined face.

**12.** A composition for thermoelectric conversion material comprising:

Ge, Mg, at least one of Sb and Bi, and Te,
the composition for thermoelectric conversion material satisfying condition (5) represented by x + a + b < 1.0,
in the condition (5),
x is the amount-of-substance ratio of the content of Ge to the content of Te,
a is the amount-of-substance ratio of the content of Mg to the content of Te, and
b is the amount-of-substance ratio of the sum of the contents of Sb and Bi to the content of Te.

**13.** A thermoelectric conversion element comprising:

a thermoelectric converter;
a first electrode electrically connected to a first end at the thermoelectric converter; and
a second electrode electrically connected to a second end at the thermoelectric converter, wherein
the thermoelectric converter comprises the thermoelectric conversion material according to any one of claims 1 to 11.

**14.** A thermoelectric conversion module comprising:

a p-type thermoelectric converter;

an n-type thermoelectric converter;

a first electrode electrically connecting a first end at the p-type thermoelectric converter to a third end at the n-type thermoelectric converter;

a second electrode electrically connected to a second end at the p-type thermoelectric converter; and

a third electrode electrically connected to a fourth end at the n-type thermoelectric converter, wherein

the p-type thermoelectric converter comprises the thermoelectric conversion material according to any one of claims 1 to 11.

15. A method for producing a thermoelectric conversion material, comprising:

energizing an alloy powder containing Ge, Mg, at least one of Sb and Bi, and Te by spark plasma sintering, and sintering the alloy powder at a temperature higher than or equal to 500°C,

the thermoelectric conversion material satisfying condition (6) represented by $x + a + b < 0.98$,

in the condition (6),

$x$ is the amount-of-substance ratio of the content of Ge to the content of Te,

$a$ is the amount-of-substance ratio of the content of Mg to the content of Te, and

$b$ is the amount-of-substance ratio of the sum of the contents of Sb and Bi to the content of Te.

# FIG. 1

# FIG. 2

# FIG. 3A

# FIG. 3B

# FIG. 4

# FIG. 5

# FIG. 6

## FIG. 7A

## FIG. 7B

## FIG. 7C

FIG. 8A

FIG. 8B

FIG. 9A

FIG. 9B

**EP 4 343 867 A1**

## INTERNATIONAL SEARCH REPORT

| International application No. |
|---|
| **PCT/JP2022/017376** |

### A. CLASSIFICATION OF SUBJECT MATTER

*H01L 35/16*(2006.01)i; *H01L 35/34*(2006.01)i
FI: H01L35/16; H01L35/34

According to International Patent Classification (IPC) or to both national classification and IPC

### B. FIELDS SEARCHED

Minimum documentation searched (classification system followed by classification symbols)

H01L35/16; H01L35/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | XING, Tong et al., Superior performance and high service stability for GeTe-based thermoelectric compounds, National Science Review, 2019, vol. 6, Issue 5, pp. 944-954, <DOI: 10.1093/nsr/nwz052> in particular, ABSTRACT, RESULTS AND DISCUSSION, METHODS | 1-15 |
| Y | TAN, Huan et al., Rapid preparation of Ge0.9Sb0.1Te1+x via unique melt spinning: Hierarchical microstructure and improved thermoelectric performance, Journal of Alloys and Compounds, 2019, vol. 774, pp. 129-136, <DOI: 10.1016/j.jallcom.2018.09.144> in particular, 3. Results and discussion | 1-15 |
| Y | XING, Tong et al., Ultralow Lattice Thermal Conductivity and Superhigh Thermoelectric Figure-of-Merit in (Mg, Bi) Co-Doped GeTe, ADVANCED MATERIALS, Wiley, 28 April 2021, vol. 33,2008773, <DOI: 10.1002/adma.202008773> in particular, 2. Results and Discussion | 1-15 |

☑ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 June 2022** | **21 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
|---|
| **PCT/JP2022/017376** |

**C.    DOCUMENTS CONSIDERED TO BE RELEVANT**

| Category* | Citation of document, with indication, where appropriate, of the relevant passages | Relevant to claim No. |
|---|---|---|
| Y | ZHENG, Zheng et al., Rhombohedral to Cubic Conversion of GeTe via MnTe Alloying Leads to Ultralow Thermal Conductivity, Electronic Band Convergence, and High Thermoelectric Performance, Journal of the American Chemical Society, American Chemical Society, 2018, vol. 140, pp. 2673-2686, <DOI: 10.1021/jacs.7b13611> <br> in particular, ABSTRACT, EXPERIMENTAL SECTION, fig. 3 | 4-5 |
| Y | WO 2019/167709 A1 (SUMITOMO CHEMICAL CO., LTD.) 06 September 2019 (2019-09-06) <br>     fig. 2, 3 | 13, 14 |

Form PCT/ISA/210 (second sheet) (January 2015)

**INTERNATIONAL SEARCH REPORT**
Information on patent family members

International application No.

**PCT/JP2022/017376**

| Patent document cited in search report | Publication date (day/month/year) | Patent family member(s) | Publication date (day/month/year) |
|---|---|---|---|
| WO 2019/167709 A1 | 06 September 2019 | US 2021/0367130 A1 fig. 2, 3 <br> CN 111758170 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. XING et al.** Superior performance and high service stability for GeTe-based thermoelectric compounds. *National Science Review,* 2019, vol. 6 (5), 944-954

- **Z. LIU et al.** Phase-transition temperature suppression to achieve cubic GeTe and high thermoelectric performance by Bi and Mn cooping. *Proceedings of the National Academy of Sciences of the United States of America,* 2018, vol. 115 (21), 5332-5337